# EUROPÄISCHE PATENTSCHRIFT

(11) **EP 0 276 753 B1**
(45) Veröffentlichungstag und Bekanntmachung des Hinweises auf die Patenterteilung: **28.04.1993**
(21) Anmeldenummer: 88100830.4
(22) Anmeldetag: 21.01.1988
(51) Int. Cl.: G11B 20/12, G11B 20/10, H04N 7/137, H04N 5/92, H04N 5/78, H04L 25/49

(54) **Verfahren und Vorrichtung zur digitalen Nachrichtenübertragung und/oder -aufzeichnung und -wiedergabe**
Method and apparatus for transmitting digital information and/or for recording and reproducing
Méthode et appareil pour la transmission d'informations numériques et/ou l' enregistrement et la reproduction

(30) Priorität: 28.01.1987 DE 3702490
(43) Veröffentlichungstag der Anmeldung: 03.08.1988
(73) Patentinhaber: Deutsche Thomson-Brandt GmbH, 78003 Villingen-Schwenningen (DE)
(72) Erfinder: Keesen, Heinz-Werner, Dr.-Ing., D-3000 Hannover 1 (DE); Peters, Hartmut, Dipl.-Ing., D-3000 Hannover 1 (DE)

(56) Entgegenhaltungen:
- US-A- 4 580 162
- IEEE TRANSACTIONS ON COMMUNICATION TECHNOLOGY. vol. 32, no. 3, März 84, NEW YORK US Seite 225 - 232; W-H Chen-and W. Pratt: "Scene Adaptive Coder"
- OPTICAL ENGINEERING. vol. 25, no. 8, August 86, BELLINGHAM US Seite 979 - 983; A. Tescher and J. Saghri: "Adaptive Transform Coding and Image Quality"
- ELECTRONICS AND COMMUNICATIONS IN JAPAN. vol. 59-A, no. 11, November 76, NEW YORK US Seite 51 - 60; Y. Sato and H. Kuroda: "DPCM Coding Method Using Variable-Length Codes for Video Telephone Signals"
- FREQUENZ. vol. 39, no. 7, August 85, BERLIN DE Seite 226 - 234; B. Hammer: "Transformationscodierung von Bildsequenzen mit der M-Hadamard-Transformation"

## Beschreibung

Die Erfindung betrifft ein Verfahren zur digitalen Nachrichtenübertragung oder Nachrichtenaufzeichnung und -wiedergabe.

Bei der Übertragung und/oder Aufzeichnung und Wiedergabe von Signalen ist die Informationsdichte oft zeitlichen Schwankungen unterworfen. Dies kann sowohl für unbehandelte Signale zutreffen als auch für solche, die zur Irrelevanz- und Redundanzreduktion mit einem Quellencoder behandelt wurden. Eine Auslegung der Übertragungsstrecke bzw. des Aufzeichnungsträgers auf die maximale Informationsdichte ist technisch aufwendig und unwirtschaftlich. Bei einer Begrenzung der Übertragungs- bzw. Aufzeichnungskapazität auf eine mittlere Informationsdichte durch zeitliche Kompression und anschließende Expansion, also durch unterschiedliche Wortlänge der Datenabschnitte in Abhängigkeit der Informationsdichte, ergibt sich das Problem, die unterschiedlich langen Datenabschnitte nach der Übertragung bzw. Aufzeichnung wiederzuerkennen. Diese Wiedererkennung wird besonders dann schwierig, wenn Störungen die Wiedererkennungskriterien beseitigen. Es kann dann der Fall eintreten, daß auch nach Abklingen der Störung eine richtige Erkennung der nachfolgenden Datenabschnitte vereitelt ist.
In "Electronics and Communications in Japan", Vol.59-A, No.5, S.51-60, wird ein Verfahren zur digitalen Nachrichtenübertragung mit variabler Codewortlänge beschrieben, bei dem Blöcke konstanter Länge mit Sync-Impulsen erzeugt und mit Füllzeichen aufgefüllt werden.

Der Erfindung liegt die Aufgabe zugrunde, ein Verfahren zur digitalen Nachrichtenübertragung oder Nachrichtenaufzeichnung und -wiedergabe so zu verbessern, daß die Einflüsse von Störungen auf die Erkennbarkeit der Datenabschnitte wesentlich verringert wird, wobei aber die Datenrate nicht künstlich erhöht werden muß.

Diese Aufgabe wird bei einem Verfahren nach dem Oberbegriff des Anspruchs 1 durch die im kennzeichnenden Teil angegebenen Merkmale gelöst. Anspruch 10 enthält eine Vorrichtung gemäß der Erfindung.

Die Erfindung kombiniert die Maßnahme der zeitlichen Kompression und Expansion der Datenabschnitte mit einem festen Zeitraster und sorgt so dafür, daß Blöcke, deren Kapazität durch die zugewiesenen Datenabschnitte nicht ausgeschöpft ist, durch andere Datenabschnitte aufgefüllt und besser ausgenutzt werden. So wird einmal die Vollständigkeit der Daten gewährleistet, zum anderen wird durch das Zeitraster ermöglicht, die Datenabschnitte durch die Zuweisung zu den Blöcken wiederzuerkennen. Der Einfluß von Störungen wird auf die unmittelbare Folge in der Veränderung einzelner Daten begrenzt und kann sich nicht mehr nachteilig auf die nachfolgende Erkennung der Datenabschnitte an sich auswirken. Diese ist vielmehr durch das starre Zeitraster der Blöcke konstanter Wortlänge gegeben.

In Weiterbildung der Erfindung können mehrere Blöcke zu einem Rahmen zusammengefaßt und innerhalb dieses Rahmens die Datenabschnitte vor der Auffüllung der Blöcke in der Summe ihrer Wortlängen mit der Summe der Wortlängen der Blöcke in Übereinstimmung gebracht werden. Diese Übereinstimmung kann in einer Vergrößerung oder Verkleinerung der originären Wortlängen der Datenabschnitte bestehen. Wichtig ist jedoch, daß die Summe der Wortlängen der Datenabschnitte höchstens gleich der Summe der Wortlängen der Blöcke ist, damit die zur Verfügung stehende Wortlänge der Blöcke optimal ausgenutzt werden kann und keine wichtige Information verloren geht. Eine gleichmäßige Irrelevanzreduktion oder Vergröberung der Information ist dabei nicht als Verlorengehen wesentlicher Informationen anzusehen. Als Übereinstimmung der Summe der Wortlängen der Datenabschnitte mit der Summe der Wortlängen der Blöcke ist es auch anzusehen, wenn die Summe der Wortlängen der Datenabschnitte etwas kleiner ist als die Summe der Wortlängen der Blöcke, also nicht alle Blöcke mit Anteilen von Datenabschnitten aufgefüllt werden. Dies wird in der Praxis häufig der Fall sein, da ein genaues Auffüllen erhebliche Koordinationszeit in Anspruch nimmt und das Ergebnis in keinem Verhältnis zum Aufwand stehen würde.

Die Erfindung betrifft ferner eine Vorrichtung zur digitalen Nachrichtenübertragung und/oder -aufzeichnung und -wiedergabe gemäß dem Oberbegriff des Anspruchs 10.

Diesbezüglich liegt ihr die Aufgabe zugrunde, eine Vorrichtung der erwähnten Art so zu verbessern, daß die Einflüsse von Störungen auf die Erkennbarkeit der Datenabschnitte wesentlich verringert wird.

Diese Aufgabe wird bei einer Vorrichtung nach dem Oberbegriff des Anspruchs 10 durch die im kennzeichnenden Teil angegebenen Merkmale gelöst.

Weiterbildungen und vorteilhafte Ausführungsformen der Erfindung ergeben sich aus den Ansprüchen 2-9, der weiteren Beschreibung und der Zeichnung, die ein Ausführungsbeispiel der Erfindung veranschaulicht.

In der Zeichnung zeigen:

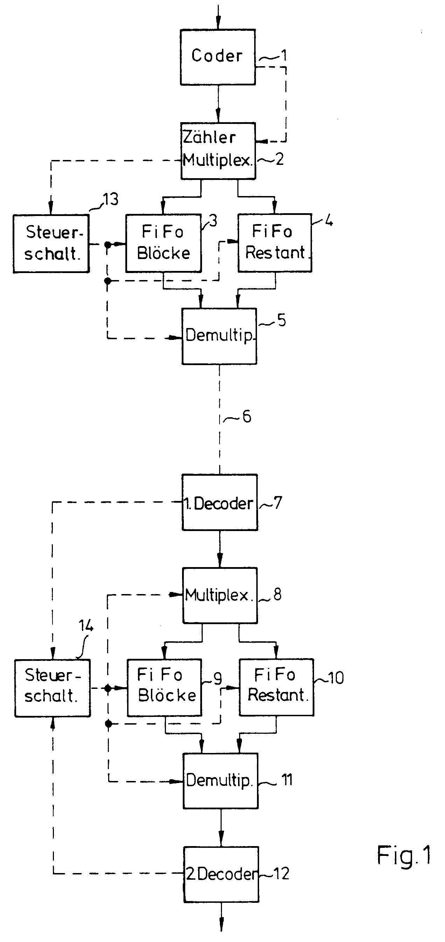

- Fig. 1: ein Blockschaltbild der Erfindung,
- Fig. 2: Darstellungen des Datenflusses über der Zeit an ausgewählten Orten der in Fig. 1 dargestellten Schaltung.

Das Blockschaltbild umfaßt in Richtung des Datenflusses betrachtet einen Coder 1, einen Multiplexer 2, eine erste Speichergruppe 3 und eine zweite, dazu alternativ anschaltbare Speichergruppe 4, einen Demultiplexer 5, eine Übertragungsstrecke oder einen Aufzeichnungsträger 6, einen ersten Decoder 7, einen zweiten Multiplexer 8, eine dritte Speichergruppe 9, eine alternativ dazu anschaltbare vierte Speichergruppe 10, einen zweiten Demultiplexer 11, einen zweiten Decoder 12, sowie eine erste Steuerschaltung 13 und eine zweite Steuerschaltung 14.

Die dem Coder 1 zugeführten Daten können z.B. digitale Videosignale sein, die durch Umwandlung mittels eines Analog/Digital-Wandlers gewonnen wurden. Soweit hier bestimmte Teile des Bildes vorgegeben sind, aus denen Datenworte gebildet werden, besitzen diese Daten eine feste Wortlänge mit einem Datenabschnittendsignal, sie weisen jedoch eine unterschiedliche Informationsdichte auf. Diese steht beim Videosignal mit der Feinstruktur des Bildes in funktionalem Zusammenhang.

Der Coder 1 ist ein Quellencoder, der aus den zugeführten Daten die redundanten und irrelevanten Anteile reduziert. Dies kann z.B. mit Hilfe einer diskreten Cosinustransformation erfolgen, dessen Ausgangssignal anschließend gewichtet wird und so unwesentliche Spektralkoeffizienten von wesentlichen getrennt werden. Am Ausgang des Coders 1 treten dann Datenabschnitte variabler Wortlänge auf. Ein Datenabschnittendsignal ist auch bei diesen Datenabschnitten vorhanden.

Mittels des ersten Multiplexers 2, der gleichzeitig einen Zähler für die Anzahl der Bits der einem Block entsprechenden Wortlänge besitzt, werden die Daten eines Datenabschnitts zunächst in die erste Speichergruppe 3 eingelesen. In dieser Speichergruppe ist für jeden Block die der Wortlänge eines Blockes entsprechende Anzahl von Speicherplätzen reserviert. Werden die Speicherplätze nicht oder gerade vollständig ausgenutzt, so bleibt es für diesen Block bei der Zuweisung zur Speichergruppe 3. Im anderen Fall wird der die Wortlänge eines Blocks übersteigende Rest in die zweite Speichergruppe 4 eingeschrieben. Danach wird in gleicher Weise der nächste Datenabschnitt einem weiteren Block zugewiesen und gespeichert.

Beim Videosignal kann ein Datenabschnitt z.B. aus einem Quadrat aus 8 X 8 Bildpunkten bestehen. Ein codierter Block dieses Datenabschnitts kann dabei 64 Bit beanspruchen. Es werden zweckmäßig alle Bildabschnitte eines Gesamtbildes zu einem Rahmen zusammengefaßt und sämtliche Blöcke eines Rahmens in der Speichergruppe 3 sowie die Datenabschnitte, deren Wortlänge die Wortlänge eines Blockes überschritten haben, in der Speichergruppe 4 gespeichert. Danach werden die Blöcke beginnend mit dem ersten Block über den Demultiplexer 5 auf die Übertragungsstrecke 6 bzw. den Aufzeichnungsträger ausgegeben und in den Fällen, in denen die vorhandene Wortlänge kleiner als die maximal mögliche ist, durch Umschalten auf die zweite Speichergruppe 4 mit den überschüssigen Anteilen der Datenabschnitte aufgefüllt. Das Ergebnis ist also eine Folge von Blöcken, die alle oder weitgehend alle die maximal mögliche Wortlänge umfassen und dabei alle Anteile aus mehreren Datenabschnitten beinhalten können. In den letzten Blöcken kann es allerdings vorkommen, daß die Blöcke nicht ganz mehr mit Anteilen von Datenabschnitten aufgefüllt werden können. In diesem Falle werden Leerstellen eingefügt. Die entsprechende Steuerung erfolgt durch die Steuerschaltung 13, die den zeitlichen Ablauf koordiniert. Die Schaltung kann sowohl hardwaremäßig aus diskreten Baugruppen als auch durch einen Rechner unter Zuhilfenahme der internen Rechnerspeicher realisiert werden.

Nach der Übertragung oder Speicherung gelangen die in die Blöcke geschachtelten Daten zum ersten Decoder 7, welcher die Blöcke auf das Datenabschnittendsignal auswertet. Der erste Teil des Blockes wird dann mittels des zweiten Multiplexers 8 in die dritte Speichergruppe 9 eingelesen, bis ein Datenabschnittendsignal auftritt. Danach schaltet der Multiplexer 8 auf die vierte Speichergruppe 10 um, in die der Restanteil eingelesen wird. Anschließend wird der nächste Block wieder zunächst in die dritte Speichergruppe 9 eingelesen. In der Speichergruppe 9 stehen jetzt wieder Blöcke, die jeweils nur noch einen Datenabschnitt beinhalten. Sofern dieser Datenabschnitt eine kleinere Wortlänge oder die gleiche Wortlänge wie die Blöcke hat, ist der Datenabschnitt vollständig. In diesem Fall wird der vollständige Datenabschnitt durch den zweiten Demultiplexer 11 auf den zweiten Decoder 12 geschaltet. Im anderen Falle, d.h. wenn der in der Speichergruppe 9 befindliche Datenabschnitt noch nicht vollständig ist, wird er mit den restlichen Anteilen ergänzt, indem mittels des Demultiplexers 11 nach dem Ende des unvollständigen Datenabschnitts von der Speichergruppe 9 auf die Speichergruppe 10 umgeschaltet wird.

Am Eingang des zweiten Decoders 12 liegen wieder Datenabschnitte variabler Wortlänge vor. Der Decoder 12 ist das Gegenstück zum Coder 1, so daß an seinem Ausgang wieder ein Datenstrom auftritt, der dem Eingangsdatenstrom des Coders 1 entspricht.

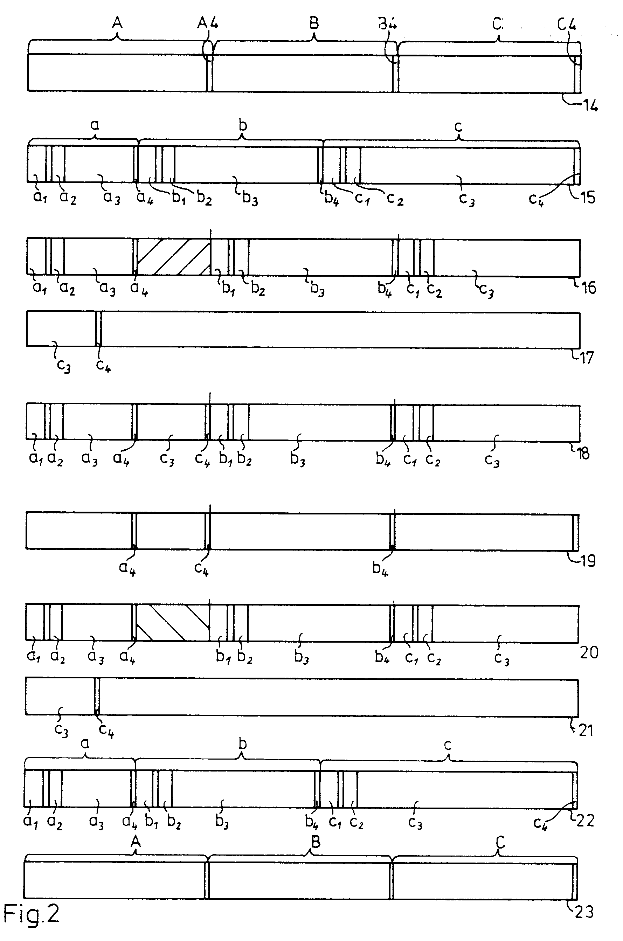

Zur Erläuterung des Datenflusses wird nun auf Fig. 2 Bezug genommen. Die Darstellung ist hier auf drei Datenabschnitte unterschiedlicher Informationsdichte beschränkt. Die Datenabschnitte vor der Codierung im Coder 1 bzw. nach der DeCodierung im Decoder 12 sind mit den Großbuchstaben A, B, C bezeichnet. Die graphische Darstellung ist in den Feldern 14 und 23 wiedergegeben. Die codierten Signale sind demgegenüber mit kleinen Buchstaben wiedergegeben. Je nach der Bedeutung des Codes tragen die Buchstaben Indizes. Der Index 1 steht für einen Gleichanteil, der Index 2 für den größten Spektralkoeffizienten, der Index 3 für untergeordnete Spektralkoeffizienten und der Index 4 für ein Datenabschnittendsignal. In dem veranschaulichten Beispiel ist das Datenabschnittsendsignal auch bereits zur Abschnittsmarkierung der nicht codierten Daten vorhanden. Bei den codierten Daten nimmt der Gleichanteil sowie der wichtigste Koeffizient und ggf. noch ein nicht gesondert mit Bezugszeichen versehenes Unterscheidungssignal für die Länge der Datenabschnitte einen festen Bereich ein. Variabel ist lediglich die durch die untergeordneten Koeffizienten vorgegebene Wortlänge.

Die Informationsdichte der Datenabschnitte ist so verteilt, daß in Abschnitt A eine geringe, in Abschnitt B eine mittlere und in Abschnitt C eine hohe Informationsdichte vorherrscht. Dies wird in Feld 15 durch die unterschiedliche Wortlänge der Datenabschnitte mit dem Index 3 veranschaulicht. Ein diesem Feld entsprechender Signalstrom tritt am Ausgang des Coders 1 auf. Feld 16 zeigt die Speicherplatzbelegung in der Speichergruppe 3 und Feld 17 diejenige in der Speichergruppe 4. Feld 16 läßt erkennen, daß den Datenabschnitten drei Blöcke gleiche Wortlänge zugewiesen sind. Der erste Block ist mit dem Datenabschnitt a nicht voll ausgefüllt, der zweite Block ist mit dem Datenabschnitt b gerade ausgefüllt, der dritte Block kann den Datenabschnitt c nicht vollständig aufnehmen. Der überschießende Teil befindet sich deshalb in der Speichergruppe 4.

Feld 18 veranschaulicht den Datenstrom hinter dem Demultiplexer 5. Wie die Zeichnung erkennen läßt, ist der freie Bereich im ersten Block mit dem restlichen Anteil des Datenabschnitts c aufgefüllt worden. Dieser Datenstrom kann nun in der dargestellten zeitlichen Abfolge übertragen und/oder gespeichert und ausgelesen werden. In Feld 19 ist dargestellt, wie die Datenabschnittendsignale vom ersten Decoder 7 zur Steuerung des Multiplexers 8 ausgewertet werden. Der Multiplexer 8 wird durch den Decoder 7 so geschaltet, daß Blöcke gleicher Länge in die Speichergruppe 9 eingelesen werden, wie es im Feld 20 gezeigt ist, und daß überschüssige Anteile von Datenabschnitten in die Speichergruppe 10 eingelesen werden, wie es Feld 21 veranschaulicht. Feld 20 entspricht dabei wieder dem Feld 16, während Feld 21 dem Feld 17 entspricht. Anschließend erfolgt durch den Demultiplexer 11 wieder eine Zuweisung der Daten zu Datenabschnitten unterschiedlicher Länge, wie es Feld 22 zeigt. Diese Darstellung entspricht Feld 15. Nach Durchlaufen des zweiten Decoders 12 wird in Feld 23 wieder das Ausgangssignal erhalten, wie es in Feld 14 dargestellt ist, womit die Signalverarbeitung abgeschlossen ist.

## Patentansprüche

1. Verfahren zur digitalen Nachrichtenübertragung oder Nachrichtenaufzeichnung und -wiedergabe, bei dem erste Datenabschnitte (A, B, C) mit variabler Wortlänge in zweite Datenabschnitte (a, b, c) mit konstanter Blocklänge umgesetzt werden, wobei gegebenenfalls Füllzeichen hinzugefügt werden und wobei die zweiten Datenabschnitte durch Endsignale (a4, b4, c4) getrennt sind, **dadurch gekennzeichnet**, daß zur Erzeugung der zweiten Datenabschnitte den ersten Datenabschnitten zunächst jeweils ein Block konstanter Wortlänge zugewiesen wird und daß anschließend die Blöcke, deren Datenabschnitte (a₁ - a₄) eine geringere Wortlänge als die der Blöcke aufweisen, mit den Rest-Anteilen (c₃) einschließlich des Endsignals (c₄) von solchen ersten Datenabschnitten aufgefüllt werden, die eine größere Wortlänge als die Blöcke haben, und daß nach der Übertragung oder für die Wiedergabe die Datenabschnitte wieder entsprechend ihrer ursprünglichen Wortlänge aus den Blöcken zusammengesetzt werden.

2. Verfahren nach Anspruch 1, **dadurch gekennzeichnet**, daß mehrere Blöcke zu einem Rahmen zusammengefaßt werden und daß innerhalb dieses Rahmens vor der Auffüllung der Blöcke die Summe der Wortlängen der ersten Datenabschnitte in Übereinstimmung mit der Summe der Wortlängen der Blöcke gebracht wird.

3. Verfahren nach Anspruch 2, **dadurch gekennzeichnet**, daß die Summe der Wortlängen der ersten Datenabschnitte durch Informationsrelevanzwichtung in Übereinstimmung gebracht wird.

4. Verfahren nach Anspruch 2, **dadurch gekennzeichnet**, daß die Summe der Wortlängen der ersten Datenabschnitte durch Quantisierungswichtung in Übereinstimmung gebracht wird.

5. Verfahren nach einem oder mehreren der Ansprüche 2 bis 4, **dadurch gekennzeichnet**, daß wesentliche Anteile der ersten Datenabschnitte unverändert gesonderten Bereichen der Blöcke zugewiesen werden und daß weniger wesentliche Anteile gewichtet und gegebenenfalls auf andere Blöcke verteilt werden.

6. Verfahren nach Anspruch 5, bei dem die Daten digitale Videosignale sind, die von einem Quellenkoder mit einem in den Spektralbereich übertragenden Transformator verarbeitet sind, **dadurch gekennzeichnet**, daß wesentliche Anteile der ersten Datenabschnitte mit dem Gleichanteil und mit einem maximalen Spektralkoeffizienten und die variablen Anteile mit untergeordneten Spektralkoeffizienten gebildet sind.

7. Verfahren nach Anspruch 6, **dadurch gekennzeichnet**, daß wesentliche Anteile zusätzlich durch ein Steuersignal zur Darstellung der Größe der ersten Datenabschnitte gebildet sind.

8. Verfahren nach einem oder mehreren der Ansprüche 5 bis 7, **dadurch gekennzeichnet**, daß ausgewählte Anteile der ersten Datenabschnitte durch Sicherungssignale besonders gegen Übertragungs- und Aufzeichnungsfehler gesichert werden.

9. Verfahren nach Anspruch 8, **dadurch gekennzeichnet**, daß die ausgewählten Anteile der Datenabschnitte ein Gleichanteil und/oder ein Wert und/oder eine Adresse eines Spektralkoeffizienten ist.

10. Vorrichtung zur digitalen Nachrichtenübertragung oder Nachrichtenaufzeichnung und -wiedergabe, bei der mittels einer Schaltungsanordnung erste Datenabschnitte (A, B, C) mit variabler Wortlänge in zweite Datenabschnitte (a, b, c) mit konstanter Blocklänge umgesetzt werden, wobei gegebenenfalls Füllzeichen hinzugefügt werden und wobei die zweiten Datenabschnitte durch Endsignale (a4, b4, c4) getrennt sind, **gekennzeichnet durch** einen auf der Quellenseite einer Übertragungsstrecke (6) bzw. eines Aufzeichnungsträgers angeordneten Zähler mit einem den Signalweg auf eine erste Speichergruppe (3) und eine zweite Speichergruppe (4) aufspaltenden Multiplexer (2), einem die Speichergruppen (3, 4) vereinigenden ersten Demultiplexer (5), durch einen auf der Sinkenseite der Übertragungsstrecke (6) bzw. des Aufzeichnungsträgers angeordneten Decoder (7), einen daran anschließenden zweiten Multiplexer (8), welcher den Signalweg auf eine dritte Speichergruppe (9) und eine vierte Speichergruppe (10) aufspaltet, einem die dritte und vierte Speichergruppe (9, 10) vereinigenden zweiten Demultiplexer (11) sowie durch eine Steuerschaltung (13) auf der Quellenseite und eine Steuerschaltung (14) auf der Sinkenseite, durch eine erste Steuerschaltung (13), die die ankommenden Datenabschnitte zunächst der ersten Speichergruppe (3) und Rest-Anteile der zweiten Speichergruppe (4) zuweist und die den erstem. Demultiplexer (5) derart steuert, daß die Rest-Anteile einschließlich der Endsignale an die Datenabschnitte nicht gefüllter Speicher der ersten Speichergruppe angefügt werden, und durch eine zweite Steuerschaltung (14), die die dritte und vierte Speichergruppe und dem zweite Demultiplexer (11) steuert, um die Datenabschnitte wieder entsprechend ihrer ursprünglichen Wortlänge zusammenzusetzen.

## Claims

1. Method for the digital transmission of communications or recording and reproduction of communications in which first data segments (A, B, C) having variable word lengths are converted into second data segments (a, b, c) having constant block lengths wherein fill characters are inserted if necessary and wherein the second data segments are separated by end signals (a4, b4, c4), characterised in that, for the production of the second data segments, a respective block of constant word length is initially allocated to the first data segments and that subsequently the blocks whose data segments (a1 - a4) exhibit a shorter word length than that of the blocks are filled with the remaining portions (c3) including the end signal (c4) of such first data segments which have a greater word length than the blocks, and that after the transmission or for the reproduction, the data segments are reconstituted from the blocks into their corresponding original word lengths.

2. Method in accordance with claim 1, characterised in that, a plurality of blocks are combined into a frame and that within this frame the sum of the word lengths of the first data segments is made equal to the sum of the word lengths of the blocks, before the filling of the blocks.

3. Method in accordance with claim 2, characterised in that, the sum of the word lengths of the first data segments is made equal by weighting relevant to the information.

4. Method in accordance with claim 2, characterised in that, the sum of the word lengths of the first data segments is made equal by quantisation weighting.

5. Method in accordance with one or more of the claims 2 to 4, characterised in that, essential portions of the first data segments are allocated unaltered to special regions of the blocks and that less essential portions are weighted and distributed as necessary to other blocks.

6. Method in accordance with claim 5, in which the data are digital video signals which are processed by a source encoder using a transformation transferring into the spectral region, characterised in that, essential portions of the first data segments are formed by the dc component and a maximum spectral coefficient and the variable portions by subordinate spectral coefficients.

7. Method in accordance with claim 6, characterised in that, essential portions are formed additionally by a control signal for the representation of the size of the first data segments.

8. Method in accordance with one or more of the claims 5 to 7, characterised in that, selected portions of the first data segments are protected, in particular against transmission and recording errors, by protection signals.

9. Method in accordance with claim 8, characterised in that, the selected portions of the data segments is a dc component and/or a value and/or an address of a spectral coefficient.

10. Device for the digital transmission of communications or recording and reproduction of communications in which first data segments (A, B, C) having variable word lengths are converted into second data segments (a, b, c) having constant block lengths by means of a circuit arrangement, wherein fill characters are inserted if necessary and wherein the second data segments are separated by end signals (a4, b4, c4), characterised by, a counter arranged on the source side of a transmission path (6) or a record carrier and having a multiplexer (2) splitting the signal path into a first storage group (3) and a second storage group (4), a first demultiplexer (5) combining the storage groups (3, 4), by a decoder (7) arranged on the sink side of the transmission path (6) or of the record carrier, a subsequent second multiplexer (8) connected thereto which splits the signal path into a third storage group (9) and a fourth storage group (10), a second demultiplexer (11) combining the third and fourth storage groups (9, 10), as well as by a control circuit (13) on the source side and a control circuit (14) on the sink side, by a first control circuit (13) which initially assigns the incoming data segments to the first storage group (3) and which controls the first demultiplexer (5) in such a way that the remaining portions including the end signals are added to the data segments of not filled stores of the first storage group, and by a second control circuit (14) which controls the third and fourth storage groups and the second demultiplexer (11) in order to reconstitute the data segments in accordance with their original word lengths.

## Revendications

1. Procédé pour la transmission numérique d'informations ou l'enregistrement et la reproduction numérique d'informations dans lequel des premières sections de données (A, B, C) de longueur de mot variable sont transformées en secondes sections de données (a, b, c) de longueur de bloc constante, des caractères de remplissage étant, le cas échéant, ajoutés, et les secondes sections de données étant séparées par des signaux de fin (a4, b4, c4), **caractérisé en ce** que, pour la production des secondes sections de données, un bloc de longueur de mot constante est tout d'abord respectivement assigné aux premières sections de données et qu'ensuite les blocs, dont les sections de données (a1-an) présentent une longueur de mot inférieure à celle des blocs sont remplis avec les sections restantes (c3), signal de fin (c4) y compris, des premières sections de données qui ont une longueur de mot plus grande que les blocs et qu'après la transmission ou pour la reproduction les sections de données sont à nouveau reconstituées à partir des blocs selon leur longueur de mot d'origine.

2. Procédé selon la revendication 1, **caractérisé en ce** que plusieurs blocs sont réunis en un cadre et qu'à l'intérieur de ce cadre la somme des longueurs de mot des premières sections est amenée, avant le remplissage des blocs, à coïncider avec la somme des longueurs de mot des blocs.

3. Procédé selon la revendication 2, **caractérisé en ce** que la somme des longueurs de mot des premières sections de données est amenée à coïncider par pondération de la signification de l'information.

4. Procédé selon la revendication 2, **caractérisé en ce** que la somme des longueurs de mot des premières sections de données est amenée à coïncider par pondération de quantification.

5. Procédé selon l'une ou plusieurs des revendications 2 à 4, **caractérisé en ce** que des portions essentielles des premières sections de données sont assignées sans être modifiées à des zones séparées des blocs et que les portions moins essentielles sont pondérées et, le cas échéant, réparties sur d'autres blocs.

6. Procédé selon la revendication 5 dans lequel les données sont des signaux numériques vidéo qui sont traités par un codeur de source avec un transformateur qui transmet dans le domaine spectral, **caractérisé en ce** que des portions esentielles des premières sections de données sont formées avec la portion continue et avec un coefficient spectral maximal et que les portions variables sont formées avec des coefficients spectraux subordonnés.

7. Procédé selon la revendication 6, **caractérisé en ce** que des portions essentielles sont formées en plus par un signal de commande pour représenter la grandeur des premières sections de données.

8. Procédé selon l'une ou plusieurs des revendications 5 à 7, **caractérisé en ce** que des portions sélectionnées des premières sections de données sont protégées par des signaux de sécurité en particulier contre les erreurs de transmission et d'enregistrement.

9. Procédé selon la revendication 8, **caractérisé en ce** que les portions sélectionnées des sections de données sont une portion continue et/ou une valeur et/ou une adresse d'un coefficient spectral.

10. Dispositif pour la transmission numérique d'informations ou l'enregistrement et la reproduction numérique d'informations dans lequel des premières sections de données (A, B, C) de longueur de mot variable sont transformées en secondes sections de données (a, b, c) de longueur de bloc constante, des caractères de remplissage étant, le cas échéant, ajoutés, et les secondes sections de données étant séparées par des signaux de fin (a4, b4, c4), **caractérisé par** un compteur placé sur le côté de la source d'un parcours de transmission (6) et/ou d'un support d'enregistrement avec un multiplexeur (2) qui décompose le parcours du signal sur un premier groupe de mémoires (3) et un second groupe de mémoires (4), un premier démultiplexeur (5) qui réunit les groupes de mémoires (3, 4), par un décodeur (7) placé sur le côté récepteur du parcours de transmission (6) et/ou du support d'enregistrement, un second multiplexeur (8) qui s'y rattache qui décompose le parcours du signal sur un troisième groupe de mémoires (9) et un quatrième groupe de mémoires (10), un second démultiplexeur (11) qui réunit le troisième et le quatrième groupe de mémoires (9, 10) ainsi que par un circuit de commande (13) sur le côté de la source et un circuit de commande (14) sur le côté récepteur, par un premier circuit de commande (13) qui affecte les sections de données qui arrivent tout d'abord au premier groupe de mémoires (3) et les portions qui restent au second groupe de mémoires (4) et qui commande le premier démultiplexeur (5) de telle manière que les portions qui restent, signaux de fin y compris, sont ajoutées aux sections de données des mémoires non remplies du premier groupe de mémoires, et par un second circuit de commande (14) qui commande le troisième et le quatrième groupe de mémoires et le second démultiplexeur (11) de manière à assembler à nouveau les sections de données selon leur longueur de mot d'origine.
